# EUROPEAN PATENT SPECIFICATION

(11) **EP 2 642 511 B1**
(45) Date of publication and mention of the grant of the patent: **25.07.2018**
(21) Application number: 11840929.1
(22) Date of filing: 18.11.2011
(51) Int. Cl.: H01L 21/027, G03F 7/20, H01L 21/67

(54) **MEMBER FOR MOUNTING AND TEMPERATURE CONTROLLED MOUNTING DEVICE**
MONTAGEELEMENT UND TEMPERATURGESTEUERTE MONTAGEVORRICHTUNG
ÉLÉMENT DE MONTAGE ET DISPOSITIF DE MONTAGE À RÉGULATION THERMIQUE

(30) Priority: 19.11.2010 JP 2010258829
(43) Date of publication of application: 25.09.2013
(73) Proprietor: Kyocera Corporation, Kyoto-shi Kyoto 612-8501 (JP)
(72) Inventor: HORIUCHI, Masahiko, Kyoto-shi Kyoto 612-8501 (JP)
(74) Representative: Viering, Jentschura & Partner mbB Patent- und Rechtsanwälte
(86) International application number: PCT/JP2011/076707
(87) International publication number: WO 2012/067239

(56) References cited:
- JP-A- 2004 311 501
- JP-A- 2004 356 624
- JP-A- 2007 242 913
- JP-A- 2010 135 508
- JP-A- 2010 258 212
- US-A1- 2005 274 325

## Description

### TECHNICAL FIELD

The present invention relates to a placement member for placing a wafer and used in a semiconductor manufacturing equipment or a flat panel display manufacturing equipment, for example, and to a temperature-control placement apparatus using the same.

### BACKGROUND ART

Conventionally, an exposure device used for manufacturing semiconductor devices or liquid crystal display devices miniaturizes a highly complicated circuit pattern and the like printed on a mask using a high-performance lens, and prints the pattern on a wafer (sample) to form a micro-pattern on the wafer. In recent years, as disclosed in JP 2004-207710 A, for example, a liquid immersion exposure technique of exposing while filling purified water between a lens and a wafer has been proposed, and micro-patterning of circuit patterns has been promoted.

However, In such a liquid immersion exposure apparatus, while only to a limited region (exposed area) on a wafer is irradiated with a laser beam, and thus thermal energy is applied, a region on the wafer excluding the exposed area may often be cooled by generation of vaporization heat due to vaporization of purified water that remains after the exposed area is transferred. As a result, a temperature difference may be produced between the plurality of regions on the wafer, The temperature difference may trigger expansion, contraction, and deformation of a wafer, and a change in exposure characteristics to a resist and such, and thus may cause a problem that it is not possible to form a desired circuit pattern on the wafer. Further, this may also cause a problem that overlay accuracy decreases as misalignment among a plurality of wiring patterns layered on the wafer may occur.

Thus, a placement member for placing a wafer as well as for reducing a temperature distribution within the wafer to keep the temperature of the wafer as a whole constant, and a temperature-control placement apparatus using the same are requested.

Documents cited during prosecution include US 2005/0274325 A1, which discloses a semiconductor heating apparatus.

### SUMMARY OF THE INVENTION

An object obtainable by embodiments of the present invention is to provide a placement member that serves a need of keeping the temperature of an entire sample constant, and a temperature-control placement apparatus using the same.

According to a first aspect of the present invention, there is provided a placement member, comprising: a main body having a placement surface on which a sample is placed; and a plurality of heating units disposed within the main body, wherein the plurality of heating units are individually temperature-controllable, characterized in that the main body has a first substrate and a second substrate joined to the first substrate, wherein the first substrate has a first main surface constituting the placement surface and a second main surface joined to the second substrate, wherein the first substrate has a plurality of first depressions in the second main surface, wherein the plurality of heating units are provided on bottom surfaces of the first depressions, and wherein an air gap are defined between the heating units and the second substrate, characterised in that the first substrate is a monolithic piece.

A temperature-control placement apparatus according to one aspect of the present invention includes: the placement member; a plurality of temperature sensors configured to detect temperatures of the plurality of heating units, respectively; and control means configured to control temperatures of the heating units corresponding to the temperature sensors according to the temperatures detected by the temperature sensors.

According to an embodiment of the placement member, it is possible to perform localized temperature-control on the placement surface, and therefore a temperature distribution within a sample placed on the placement surface may be reduced.

According to an embodiment of the temperature-control placement apparatus, it is possible to perform localized temperature-control on the placement surface of the placement member, and therefore a temperature distribution within a sample placed on the placement surface may be reduced.

### BRIEF DESCRIPTION OF THE DRAWINGS

For a better understanding of the invention, reference will now be made, by way of example only, to the following drawings, in which:
Fig. 1 is a diagram schematically illustrating a configuration example of an exposure device using a placement member according to one embodiment of the present invention.
Fig. 2 is a perspective view of the placement member according to the one embodiment of the present invention viewed obliquely downward.
Fig. 3 is a perspective view of the placement member according to the one embodiment of the present invention viewed obliquely upward.
Fig. 4 is an exploded perspective view of the placement member according to the one embodiment of the present invention.
Fig. 5(a) is a cross-sectional view of the placement member according to the one embodiment of the present Invention, and Fig. 5(b) Is a partially enlarged view of Fig. 5(a).
Fig. 6 Is a perspective view of an example of deformation of the placement member according to the one embodiment of the present invention viewed obliquely upward.
Fig. 7 is an exploded perspective view of the placement member of Fig. 6.
Fig. 8 is a diagram schematically illustrating a configuration in which temperature control means is connected to the placement member.
Fig. 9 is a diagram illustrating one example of a method of manufacturing a placement member according to one embodiment of the present invention.
Fig. 10 is a diagram illustrating one example of a method of manufacturing a placement member according to one embodiment of the present invention.

### EMBODIMENT OF THE INVENTION

Hereinafter, an embodiment of the present invention will be described with reference to the drawings.

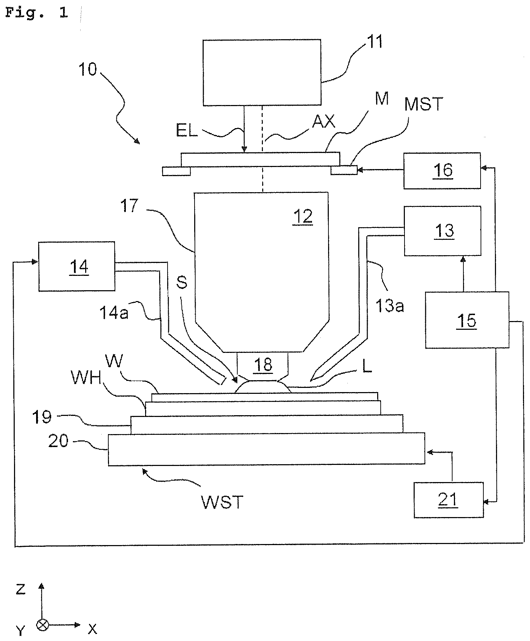

An exposure device 10 illustrated as one example in Fig. 1 is provided with a mask stage MST for supporting a mask M, a wafer stage WST for supporting a wafer W (sample) made of a semiconductor material, an illumination optical system 11 for irradiating the mask M supported on the mask stage MST with exposure light EL, a projection optical system 12 for performing projection exposure to the wafer W supported on the wafer stage WST with the exposure light EL that has passed through the mask M, a liquid supply apparatus 13 for supplying liquid L to the wafer W through a supply tube 13a, a liquid collecting apparatus 14 for collecting the liquid L that has run out from the wafer W through a collecting tube 14a, and a control device 15 for integrally controlling an operation of the exposure device 10 as a whole.

The following describes a case in which a scanning type exposure apparatus for exposing the wafer W with a pattern formed on the mask M while synchronously moving the mask M and the wafer W in directions different from each other with respect to a scanning direction (opposite directions) (a so-called scanning stepper) is used as the exposure device 10 is taken as an example. Further, a direction that matches a light axis AX of the projection optical system 12 is taken as a Z-axis direction, a direction of the synchronous movement (scanning direction) of the mask M and the wafer W within a plane perpendicular to the Z-axis direction is taken as an X-axis direction, and a direction perpendicular to the Z-axis direction and the X-axis direction is taken as a Y-axis direction. Moreover, an X-axial, a Y-axial, and a Z-axial rotation directions are respectively taken as a θX, a θY, and a θZ directions. Here, the "mask" includes a reticle in which a device pattern to be printed on a substrate by reduced projection is formed.

The illumination optical system 11 is configured to irradiate the mask M supported on the mask stage MST with the exposure light EL, and provided with an exposure light source, an optical integrator configured to uniformize illumination intensities of light fluxes emitted from the exposure light source, a condenser lens configured to collect the exposure light EL from the optical integrator, a relay lens system, a variable field stop configured to set an region illuminated by the exposure light EL on the mask M to be slit-like. A predetermined irradiation region on the mask M is irradiated with the exposure light EL of a uniform illumination intensity distribution by the illumination optical system 11. Examples of the exposure light EL emitted from the illumination optical system 11 include deep ultraviolet light (DUV light), such as bright lines in an ultraviolet region emitted from a mercury lamp (g line, h line, and i line) and KrF excimer laser light (wavelength 248 nm), and vacuum ultraviolet light (VUV light), such as ArF excimer laser light (wavelength 193 nm) or F₂ laser light (wavelength 157 nm). In order to employ the liquid immersion exposure technique, it is preferable to use ArF excimer laser light as the exposure light EL.

The mask stage MST is configured to support the mask M, and able to move two-dimensionally within a plane perpendicular to the light axis AX of the projection optical system 12, i.e., an XY plane, and to make small rotation in the θZ direction. The mask stage MST is driven by a mask stage driving unit 16 such as a linear motor. The mask stage driving unit 16 is controlled by the control device 15. A two-dimensional position and a rotational angle of the mask M on the mask stage MST are measured in real time by a laser interferometer, for example, and a result of the measurement is outputted to the control device 15. The control device 15 locates the mask M supported on the mask stage MST by driving the mask stage driving unit 16 based on the result of the measurement by the laser interferometer.

The projection optical system 12 is configured to perform projection exposure of a pattern of the mask M to the wafer W at a predetermined projection magnification β, and is configured by a plurality of optical devices (lenses), and the optical devices are supported by a lens tube 17 as a metallic member. In this embodiment, the projection optical system 12 is a reducing system with the projection magnification β being 1/4 or 1/5, for example. Alternatively, the projection optical system 12 may be either of a unit system and a magnifying system. Further, on a side of a tip end of the projection optical system 12 of this embodiment (side of the wafer W), the optical devices (lenses) 18 project from the lens tube 17.

The wafer stage WST is configured to support the wafer W, and has a stage 19 for holding the wafer W by way of a placement member WH (substrate holder), and a base 20 for supporting the stage 19. The stage 19 may be configured integrally by a Z stage and an XY stage, or by a combination of the Z stage and the XY stage that are formed separately. The wafer stage WST is driven by a wafer stage driving unit 21 such as a linear motor. The wafer stage driving unit 21 is controlled by the control device 15. For example, by driving the Z stage unit of the stage 19, positions of the wafer W in the Z-axis direction (focus position), the θX direction, and the θY direction are controlled. Further, by driving the XY stage unit of the stage 19, a position of the wafer W in the XY direction (position in a direction substantially parallel to an image surface of the projection optical system 12) is controlled. Specifically, the Z stage unit controls the focus position and the inclined angles of the wafer W to perform calibration of a surface of the wafer W with the image surface of the projection optical system 12 by auto-focusing and auto-leveling, and the XY stage unit locates the wafer W in the X-axis direction and the Y-axis direction.

The exposure device 10 employs the liquid immersion exposure technique, in order to substantially decrease an exposure wavelength to improve resolution as well as to substantially increase a focus depth. Therefore, at least while printing an image of the pattern of the mask M to the wafer W, the predetermined liquid L is filled between the surface of the wafer W and a tip end surface (lower surface) of the optical devices (lenses) 18 of the projection optical system 12 on the side of the wafer W. As described above, the lenses 18 are exposed on the side of a tip end of the projection optical system 12, and the liquid L is supplied so as to contact only with the lenses 18. Further, as tip end surfaces of the lenses 18 are sufficiently smaller than the lens tube 17 of the projection optical system 12 and the wafer W, and as the liquid L is in contact only with the lenses 18 as described above, the liquid L is locally filled on a side of the image surface of the projection optical system 12. Specifically, a liquid immersion portion provided within a space S between the projection optical system 12 and the wafer W is sufficiently smaller than the wafer W. In the exposure device 10, purified water is used as the liquid L. The purified water allows transmission of the exposure light EL including, not only ArF excimer laser light, but also deep ultraviolet light (DUV light), for example, such as bright lines in the ultraviolet region emitted from a mercury lamp (g line, h line, and i line) and KrF excimer laser light (wavelength 248 nm).

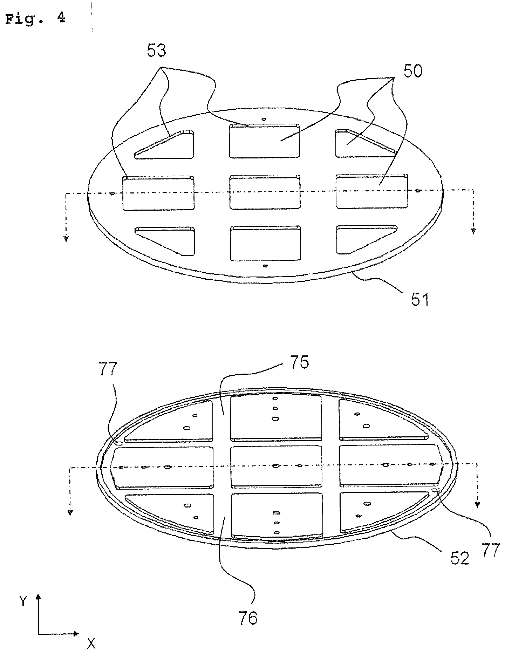

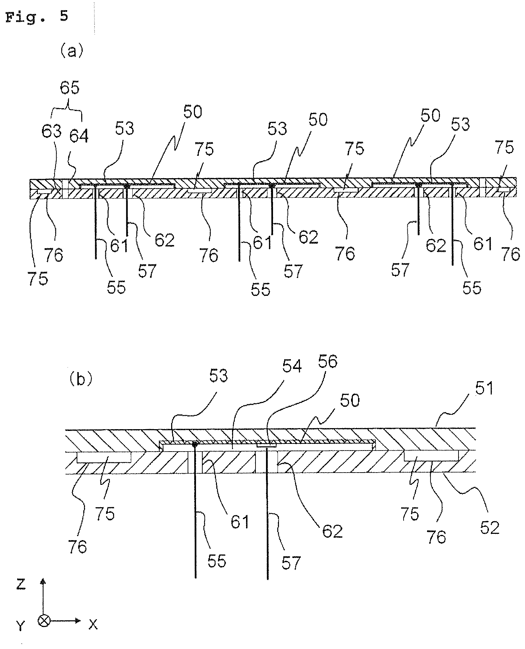

The placement member WH according to this embodiment serves as a vacuum chuck in the exposure device 10, and is configured to hold the wafer W (sample) . As illustrated in Fig. 4 and Fig. 5, the placement member WH is provided with a main body 40 having a placement surface on which the wafer W is placed. Further, the placement member WH has a plurality of heating units 50 within the main body 40. These heating units 50 are able to individually control the temperature. According to this configuration, when the temperature of the wafer W placed on the placement surface of the main body 40 partiality falls, one of the heating units 50 that is under a portion at which the temperature falls (hereinafter also referred to as a "decreased-temperature portion") or closest to the decreased-temperature portion is caused to produce heat, and thus the heat may be supplied to the decreased-temperature portion. With this, it is possible to suppress an increase of the temperature distribution of the wafer W as a whole placed on the placement surface, and to keep the wafer W as a whole at a constant temperature. Preferably, the plurality of heating units 50 are arranged evenly, instead of eccentrically, when the main body 40 is viewed from above. Here, cases in which the temperature of the wafer W partiality falls include a case in which the wafer W is cooled by generation of vaporization heat due to vaporization of purified water that remains after the exposed area is transferred in the liquid immersion exposure apparatus, for example.

These heating units 50 are arranged as close to the placement surface on which the wafer W is placed as possible, so that the heat from the heating units 50 may be transferred to the placement surface faster and more efficiently. In recent years, the number of wafers to be exposed per unit time with the exposure device is over 100, and exposure time per wafer is in the order of 30 seconds. In order to achieve a highly accurate circuit pattern and high overlay accuracy, it is required to correct the temperature distribution produced in a single wafer and to adjust the wafer as a whole to be at a constant temperature within this short period of time. Thus, it is preferable that the heating units 50 be arranged closely to the placement surface like the case of the placement member WH according to this embodiment.

Further, it is preferable that the placement member WH have, within the main body 40, a plurality of cavities aligned along the placement surface, and that the heating units 50 be provided within the cavities along the placement surface.

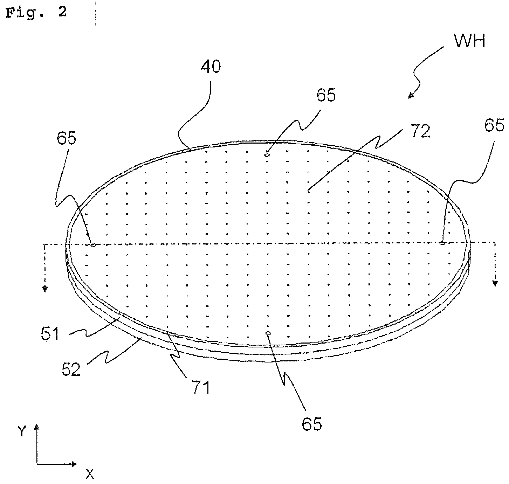

The heating units 50 as described above are provided in the following manner, for example. As illustrated from Fig. 2 through Fig. 5, the main body 40 has a first substrate 51 and a second substrate 52 joined to this first substrate 51. The first substrate 51 has one main surface constituting a placement surface and the other main surface joined to the second substrate 52. The second substrate 52 has a main surface joined to the first substrate 51, and a main surface on a side opposite of this surface (hereinafter referred to as a "non-placement surface"). The first substrate 51 has a plurality of depressions (hereinafter referred to as "first depressions") 53 in the other main surface. The heating units 50 are provided on bottom surfaces of the first depressions 53. With this, it is possible to arrange the heating units 50 closer to the placement surface than to the non-placement surface of the placement member WH, and to transfer the heat to the wafer W placed on the placement surface more efficiently.

Further, when the first substrate 51 and the second substrate 52 are joined, an air gap 54 is defined between the heating units 50 and the second substrate 52. With this, the heat generated by the heating units 50 becomes more easily transferred to the first substrate 51 than to the second substrate 52. As a result, the heating units 50 are able to transfer the heat to the wafer W placed on the placement surface more efficiently. It is preferable that the air gap 54 be an open system, for example, and includes air within. Alternatively, the air gap 54 may be in a vacuum state, or may include a member having lower thermal conductivity than the first substrate 51 and the second substrate 52 do.

Here, in order to make the heat be more easily transferred from the heating units 50 to the placement surface and from the placement surface to the heating units 50, it is desirable that at least the first substrate 51 be made of silicon carbide (SiC) having high thermal conductivity. Alternatively, the first substrate 51 may be provided using, other than silicon carbide, a inorganic insulation material such as silicon nitride or aluminum oxide. Further, the second substrate 52 may be provided using a inorganic insulation material similar to the first substrate 51. In particular, it is preferable that the second substrate 52 be made of a material of the kind used for the first substrate 51, in order reduce a difference of thermal expansion with the first substrate 51.

The heating units 50 are made of a metal such as tungsten, for example. A film of the metal is directly formed on the first substrate 51 using a method such as the PVD method and the thermal spraying method. Further, each of the heating units 50 is connected to a pair of current lines 55 for feeding a current to the heating units 50. The current lines 55 are coated copper wires, for example, and connected to the heating units 50 using solder, an electrically conductive adhesive, or the like. Here, as the electrically conductive adhesive, an adhesive made of a resin in which metallic particles are dispersed may be used, for example.

Further, to each of the heating units 50, a temperature sensor 56 for detecting the temperature of the corresponding heating unit 50 is attached. The temperature sensor 56 is a resistance temperature detector or a thermocouple, for example. During the use of the placement member WH, the temperature sensors 56 continuously measure the temperature, and if there is a difference between the temperature of the heating units 50 detected by the temperature sensors 56 and a preset temperature (desired temperature), it is possible to cause one of the heating units 50 at a lower temperature to generate heat to reduce the temperature difference, and thus to maintain the placement surface as a whole at a constant temperature. Here, in the placement member WH according to this embodiment, as the heating units 50 are provided close to the placement surface, the rise and fall of the temperature on the placement surface is linked to the rise and fall of the temperature of the heating units 50. Specifically, when the temperature of one portion of the placement surface falls, the temperature of the corresponding heating unit 50 also falls. With this, it is possible to learn the fall of the temperature of the placement surface by detecting the temperature of the heating units 50. On the other hand, when the temperature of one of the heating units 50 rises, the temperature of the portion of the placement surface corresponding to this heating unit 50 also rises. Thus, it is possible to partially control the temperature of the placement surface by controlling the temperature of the heating units 50.

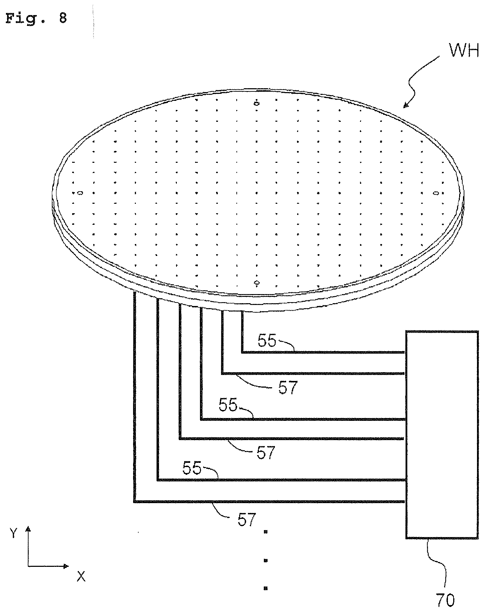

In order to enable such temperature-control, the placement member WH may be connected to control means for controlling, according to the temperature detected by the temperature sensors 56, the corresponding heating units 50. Fig. 8 schematically illustrates a configuration in which such control means is connected to the placement member WH. As illustrated in Fig. 8, the temperature detected by the temperature sensors 56 is transmitted to a temperature control device 70 via signal lines 57, and the temperature control device 70 causes the corresponding heating units 50 to generate heat according to the transmitted temperature. Here, the placement member WH, the temperature sensors 56, and the temperature control device 70 constitute a temperature control placement apparatus. The temperature control device 70 may be included in the control device 15 illustrated in Fig. 1.

Further, it is preferable to remove a part of, preferably, a center part of the heating units 50, and to attach the temperature sensors 56 directly to the first substrate 51 at portions exposed after the removal. In this manner, it is possible to dispose the temperature sensors 56 closer to the placement surface, and to detect the temperature of the placement surface more correctly.

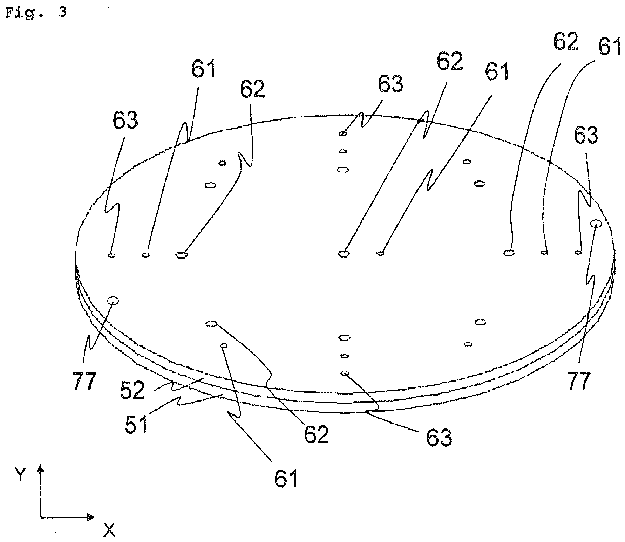

As illustrated in Fig. 3 and Fig. 5, the second substrate 52 is provided with a plurality of through holes . These through holes include through holes (first through holes) 61 through which the current lines 55 for feeding a current to the heating units 50 are inserted, through holes (second through holes) 62 through which the signal lines 57 connected to the temperature sensors 56 are inserted, and suction holes 63. The suction holes 63 are communicated with the suction holes 64 provided for the first substrate 51, respectively, and together constitute suction through holes 65 that penetrate through the placement member WH. The placement surface of the placement member WH is provided with an annular wall 71, for example, along its outer circumference, and when the wafer W is placed on the placement surface, a space is defined among the annular wall 71, the placement surface, and the wafer W. When air within this space is sucked through the suction through holes 65, the wafer W is sucked to the placement surface of the placement member WH. Here, as illustrated in Fig. 2, the placement surface of the placement member WH may include pin-shaped projections 72. In this case, a contacting area between the wafer W and the placement surface decreases, and it is possible to reduce particles from being produced, and to facilitate removal of the wafer W when the suction stops.

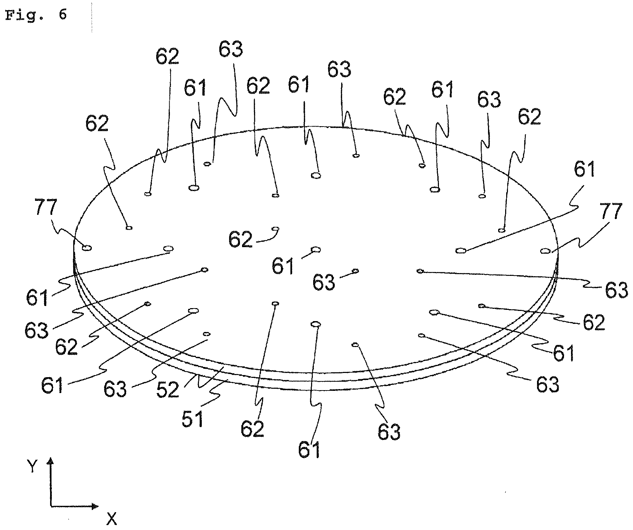

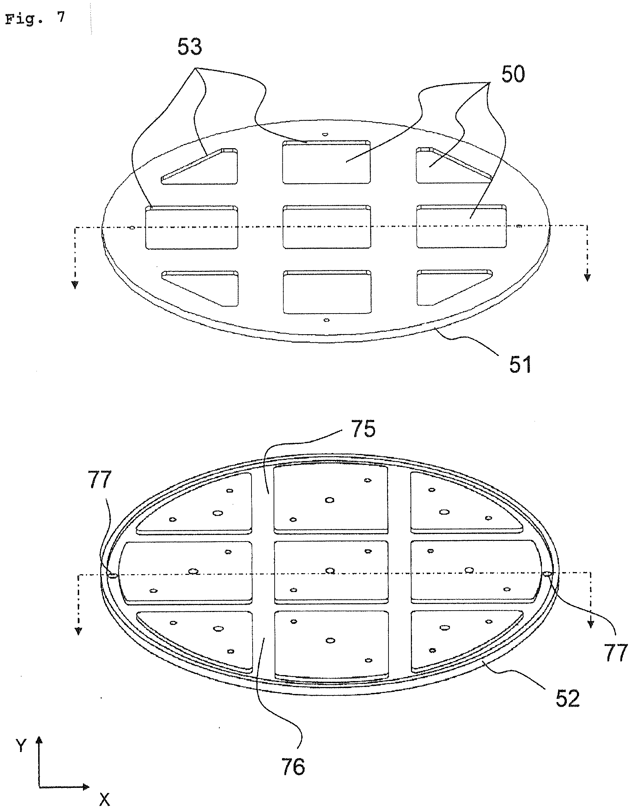

Further, through the first through holes 61, the pair of current lines 55 which is a bundle of two current lines 55 may be inserted, or the current lines 55 may be inserted respectively. Fig. 3 and Fig. 5 illustrate a configuration in which the pair of current lines 55 is inserted. A tip end of the pair of current lines 55 inserted through the first through holes 61 is branched within the first depressions 53, and individually connected to the same one of the heating units 50 by solder and the like. Here, Fig. 6 and Fig. 7 illustrate perspective views of a case in which the current lines 55 are respectively inserted through the first through holes 61.

Further, through the second through holes 62, the pair of signal lines 57 which is a bundle of two signal lines 57 may be inserted, or the signal lines 57 may be inserted respectively.

Here, as illustrated in Fig. 4 and Fig. 5, in the placement member WH according to this embodiment, in order to connect each current line 55 to and attach each temperature sensor 56 to each of the heating units 50, one of the first through holes 61 and one of the second through holes 62 are both connected to one of the first depressions 50. Among the first through hole 61 and the second through hole 62 connected to one of the first depression 50, it is preferable that the second through hole 62 be positioned closer to a side of a central portion of the first depression 50 than the first through holes 61 is. With this, the temperature sensors 56 connected to the signal lines 57 may be arranged closer to the side of the central portion of the first depression 50 than to the connected portion of the current lines 55 to the heating units 50. As a result, it is possible to arrange the temperature sensors 56 closer to a central portion of a temperature measurement region, and to improve accuracy in the temperature measurement by the temperature sensors 56.

Further, the placement member WH according to this embodiment is provided with flow channels 75 within. The flow channels 75 are provided evenly, instead of eccentrically, when the placement member WH is viewed from above, and extends in a latticed pattern or in a meandering manner, for example. When liquid at 20-25 °C, for example, runs through the flow channels 75, the liquid flows evenly through the placement member WH, and therefore it is possible to prevent the temperature difference from being produced over the placement member WH. Thus, the placement surface of the placement member WH on which a wafer is placed, it is possible to suppress an increase of the temperature distribution, and to keep the placement surface as a whole at a constant temperature.

Further, the placement member WH according to this embodiment, when viewed from above, a total area of the flow channels 75 is smaller than a total area of the heating units 50. Accordingly, by increasing regions in the placement surface of the placement member WH having the heating units 50 immediately below while controlling the temperature of the placement surface as a whole by the flow channels 75, it is possible to increase regions in which localized temperature-control is possible and to maintain the temperature in each region of the placement surface to be more constant. In order to achieve the above configuration, it is preferable that a width of the flow channels 75 be smaller than a width of the heating units 50 in a cross section of the placement member WH taken along a direction perpendicular to a longitudinal direction of the flow channels 75.

The flow channels 75 are provided by defining a plurality of groove-shaped depressions (hereinafter referred to as "second depressions") 76 in the main surface of the second substrate 52 joined to the first substrate 51. At this time, the second depressions 76 are positioned in the second substrate 52 at portions corresponding to portions between the first depressions 53 when the first substrate 51 and the second substrate 52 are joined. In this manner, when the second depressions 76 are defined in the second substrate 52 at the portions corresponding to portions between the first depressions 53, the liquid that runs through the flow channel 76 may not be brought into contact with the heating units 50, and therefore it is possible to prevent the heating units 50 from corrosion, to prevent the heat generated by the heating units 50 from being transferred to the liquid, and thus to prevent the temperature of the liquid from changing. Here, as illustrated in Fig. 3 and Fig. 6, the second substrate 52 is provided with openings for liquid 77 communicated with the flow channels 75. These openings for liquid 77 serve as inlets and outlets for the liquid.

Alternatively, the flow channels 75 may be provided for the first substrate 51. In this case, the flow channels 75 may be defined by providing the second depressions 76 between the plurality of first depressions 53 in the main surface of the first substrate 51 joined to the second substrate 52.

Moreover, the flow channels 75 may be provided for both of the first substrate 51 and the second substrate 52. As a result, a thickness of the flow channels 75 may be greater than that of the first depressions 53. In this case, the flow channels 75 may be defined by providing the second depressions 76 at corresponding portions both in the first substrate 51 and the second substrate 52.

The heating units 50 are preferably provided along the flow channels 75. As illustrated in Fig. 4, for example, when the flow channels 75 are defined in a latticed pattern, the heating units 50 are provided so as to be positioned between the lattice, or between the lattice and an outer edge of the placement member WH when the placement member WH is viewed from above. In such a configuration, as the flow channels 75 are provided between the adjacent heating units 50, by reducing the heat propagation between the adjacent heating units 50 by the flow channels 75, it is possible to improve accuracy in temperature-control of the individual heating units 50.

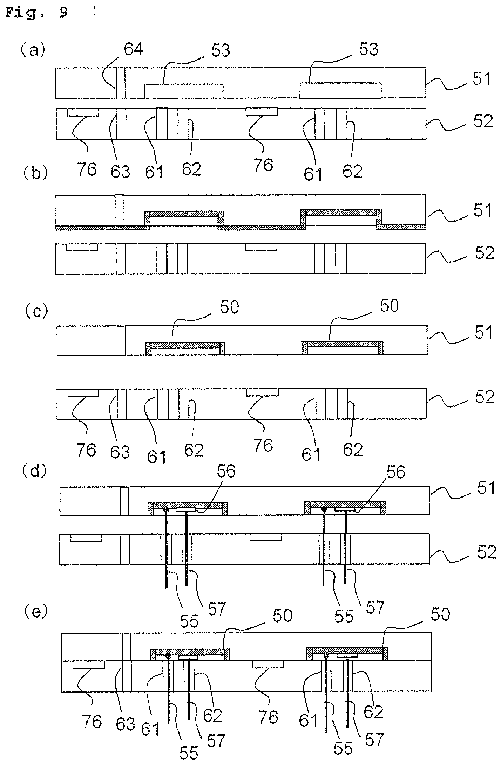

Hereinafter, a method of manufacturing the placement member WH according to this embodiment is described with reference to Fig. 9. First, (a) the first substrate 51 having the first depressions 53 and the second substrate 52 having the second depressions 76 are prepared. If the first substrate 51 and the second substrate 52 are made of ceramics, the first depressions 53 and the second depressions 76 may be provided by a cutting process before firing, or may be provided by a grinding process after firing.

An interval between the first depressions 53 may be determined considering insulation properties, and is preferably equal to or greater than 2 mm. Further, it is necessary to set a sufficient distance as a distance between an end surface of the first substrate 51 and the first depressions 53 considering a linear expansion coefficient and a temperature of the generated heat, in order to suppress expansion of the heating units 50 provided for the first depressions 53 due to the heat generation and thus deformation of the placement surface. Preferably, the distance may be equal to or greater than 0.05 mm.

Further, the second substrate 52 is provided with, in addition to the second depressions 76, the first through holes 61, the second through holes 62, and the suction holes 63. The first substrate 51 is provided with, in addition to the first depressions 53, the suction holes 64 communicated with the suction holes 63 of the second depressions 76.

Next, (b) a conducting film for heating units is formed in the first depressions 53 of the first substrate 51. This is achieved by forming a thin film of a metal such as tungsten over the main surface as a whole in which the first depressions 53 of the first substrate 51 are provided, that is, within the first depressions 53 and over a region on the main surface other than the first depressions 53. Such a thin film may be formed using a method such as the PVD method and the thermal spraying method, for example.

Then, (c) the individual heating units 50 are provided. This is achieved by grinding the main surface of the first substrate 51 on which the conducting film for heating units is formed in the step (b). At this time, the main surface of the first substrate 51 is ground until the conducting film for heating units formed over the region other than the first depressions 53 is removed. With this, the conducting film remains only within the first depressions 53, i.e. , only on the bottom surface and a side surface, and this film constitute the heating units 50. As described above, by providing the heating units 50 not only on the bottom surfaces, but also on the side surface of the first depressions 53, it is possible to control lateral heat propagation of the placement member WH.

In forming the conducting film for heating units after the step (a), a mask may be applied over the region other than the first depressions 53 in the main surface of the first substrate 51, and the film may be formed selectively only on the bottom surfaces and the side surfaces of the first depressions 53. Further, using a mask in a similar manner, the film may be formed selectively over the entirety of or a part of the bottom surfaces of the first depressions 53. Moreover, the heating units 50 may be joined to the first substrate 51 using a joining material having high thermal conductivity. As such a joining material, an adhesive made of a resin in which metallic particles are dispersed may be used, or an adhesive made of a silicone resin may be used. In the cases in which the mask is used or the heating units 50 are joined using a joining material, the step (c) may be omitted.

Next, (d) the current lines 55 to be connected to the heating units 50 are inserted into the first through holes 61 of the second substrate 52, and the tip ends of the current lines 55 are connected to the heating units 50 using solder, an electrically conductive adhesive, or the like. Further, the temperature sensors 56 are attached to the heating units 50 using an insulating adhesive having high thermal conductivity, and the signal lines 57 connected to the temperature sensors 56 are inserted into the second through holes 62 of the second substrate 52. As such an insulating adhesive, an adhesive made of a silicone resin or an epoxy resin but not containing metallic particles may be used, for example.

Finally, (e) the main surface of the first substrate 51 in which the first depressions 53 are provided and the main surface of the second substrate 52 in which the second depressions 76 are provided are joined. At this time, examples of the joining material joining the first substrate 51 and the second substrate 52 include glass and the like.

In this manner, the placement member WH according to this embodiment may be manufactured.

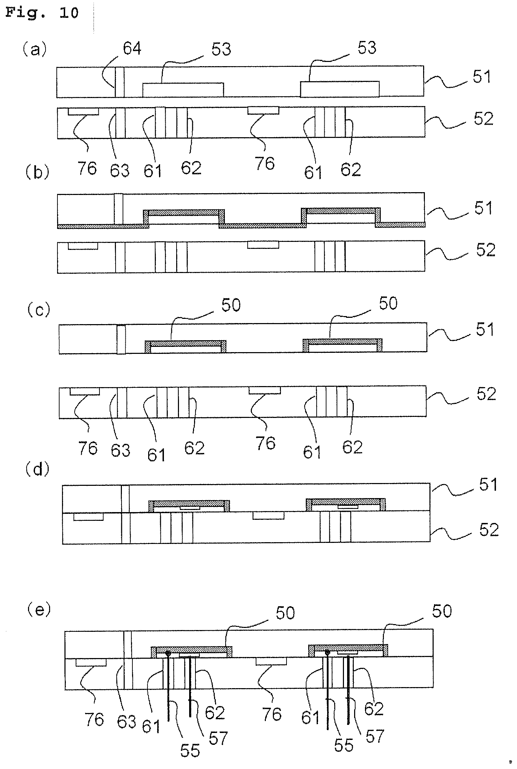

It should be noted that, as illustrated in Fig. 10, the main surface of the first substrate 51 in which the first depressions 53 are provided and the main surface of the second substrate 52 in which the second depressions 76 are provided may be joined after the step (c) and before connecting the current lines 55 to the heating units 50. In this case, after the step (c), the first substrate 51 and the second substrate 52 may be joined after attaching the temperature sensors 56 to the heating units 50 of the first substrate 51, and then, the current lines 55 and the signal lines 57 may be inserted into the first through holes 61 and the second through holes 63 of the second substrate 52, respectively, and then connected to the heating units 50 and the temperature sensors 56.

Further, the order of the steps including joining the first substrate 51 and the second substrate 52, connecting the current lines 55 to the heating units 50, and connecting the signal lines 57 to the temperature sensors 56 may be altered according to the temperature when joining or connecting. For example, if the temperature in joining the first substrate 51 and the second substrate 52 is higher than the temperature in connecting the current lines 55 to the heating units 50, the current lines 55 may be connected to the heating units 50 after the first substrate 51 and the second substrate 52 are joined as illustrated in Fig. 10.

### REFERENCE MARKS IN THE DRAWINGS

- WH: placement member
- 10: exposure device
- 50: heating unit
- 51: first substrate
- 52: second substrate
- 53: first depression
- 55: current line
- 56: temperature sensor
- 57: signal line
- 61: first through hole
- 62: second through hole
- 65: suction through hole
- 70: temperature control device
- 75: flow channel
- 76: second depression

## Claims

1. A placement member, comprising:
a main body having a placement surface on which a sample is placed; and
a plurality of heating units (50) disposed within the main body, wherein the plurality of heating units (50) are individually temperature-controllable, **characterized in that**
the main body (40) has a first substrate (51) and a second substrate (52) joined to the first substrate (51),
wherein the first substrate (51) has a first main surface constituting the placement surface and a second main surface joined to the second substrate (52),
wherein the first substrate (51) has a plurality of first depressions in the second main surface,
wherein the plurality of heating units (50) are provided on bottom surfaces of the first depressions, and
wherein an air gap (54) is defined between the heating units (50) and the second substrate (52),
**characterised in that** the first substrate is a monolithic piece.

2. The placement member according to Claim 1, wherein the first substrate (51) is made of an inorganic insulation material.

3. The placement member according to Claim 1 or 2, wherein the first substrate (51) is made of silicon carbide (SiC).

4. The placement member according to any one of claims 1 to 3, wherein
the main body has a non-placement surface on a side opposite to the placement surface, and
the plurality of heating units (50) are disposed closer to the placement surface than to the non-placement surface.

5. The placement member according to any one of claims 1 to 4, wherein
the heating units (50) are configured by metal thin films.

6. The placement member according to any one of claims 1 to 5, wherein
the main body has flow channels (75) provided along the placement surface therein, and
the second substrate (52) has one main surface joined to the other main surface of the first substrate (51), the one main surface of the second substrate (52) has second depressions constituting the flow channels (75) at portions corresponding to portions between adjacent ones of the plurality of first depressions.

7. A temperature-control placement apparatus, comprising:
the placement member according to one of claim 1 to claim 6;
a plurality of temperature sensors (56) configured to detect temperatures of the plurality of heating units, respectively; and
control means configured to control temperatures of the heating units corresponding to the temperature sensors (56) according to the temperatures detected by the temperature sensors (56).

## Patentansprüche

1. Ein Platzierungselement, aufweisend:
einen Hauptkörper, der eine Platzierungsfläche aufweist, auf welcher eine Probe platziert ist, und
eine Mehrzahl von Heizeinheiten (50), die innerhalb des Hauptkörpers angeordnet sind, wobei die Mehrzahl von Heizeinheiten (50) einzeln temperaturregelbar sind, **dadurch gekennzeichnet, dass**
der Hauptkörper (40) ein erstes Substrat (51) und ein zweites Substrat (52) aufweist, das mit dem ersten Substrat (51) verbunden ist,
wobei das erste Substrat (51) eine erste Hauptfläche, die die Platzierungsfläche bildet, und eine zweite Hauptfläche aufweist, die mit dem zweiten Substrat (52) verbunden ist,
wobei das erste Substrat (51) eine Mehrzahl von ersten Vertiefungen in der zweiten Hauptfläche hat,
wobei die Mehrzahl von Heizeinheiten (50) auf Bodenflächen der ersten Vertiefungen vorgesehen ist, und
wobei ein Luftspalt (54) zwischen den Heizeinheiten (50) und dem zweiten Substrat (52) definiert ist,
**dadurch gekennzeichnet, dass** das erste Substrat ein monolithisches Stück ist.

2. Das Platzierungselement gemäß Anspruch 1, wobei das erste Substrat (51) aus einem anorganischen Isolationsmaterial gebildet ist.

3. Das Platzierungselement gemäß Anspruch 1 oder 2, wobei das erste Substrat (51) aus Siliciumcarbid (SiC) gebildet ist.

4. Das Platzierungselement gemäß irgendeinem der Ansprüche 1 bis 3, wobei
der Hauptkörper eine Nicht-Platzierungsfläche auf einer Seite entgegengesetzt zu der Platzierungsfläche hat, und
die Mehrzahl von Heizeinheiten (50) näher bei der Platzierungsfläche als bei der Nicht-Platzierungsfläche angeordnet ist.

5. Das Platzierungselement gemäß irgendeinem der Ansprüche 1 bis 4, wobei
die Heizeinheiten (50) durch Metalldünnschichten konfiguriert sind.

6. Das Platzierungselement gemäß irgendeinem der Ansprüche 1 bis 5, wobei
der Hauptkörper Strömungskanäle (75) hat, die darin entlang der Platzierungsfläche vorgesehen sind, und
das zweite Substrat (52) eine Hauptfläche hat, die mit der anderen Hauptfläche des ersten Substrats (51) verbunden ist, wobei die eine Hauptfläche des zweiten Substrats (52) zweite Vertiefungen hat, die an Abschnitten, die mit Abschnitten zwischen benachbarten aus der Mehrzahl von ersten Vertiefungen korrespondieren, die Strömungskanäle (75) bilden.

7. Eine Temperaturregelungs-Platzierungsvorrichtung, aufweisend:
das Platzierungselement gemäß einem von Anspruch 1 bis Anspruch 6,
eine Mehrzahl von Temperatursensoren (56), die konfiguriert sind, um Temperaturen der Mehrzahl von Heizeinheiten zu detektieren, und
Regelungsmittel, die konfiguriert sind, um Temperaturen der Heizeinheiten entsprechend den Temperatursensoren (56) gemäß den von den Temperatursensoren (56) detektierten Temperaturen zu regeln.

## Revendications

1. Un élément de placement, comportant :
un corps principal ayant une surface de placement sur laquelle un échantillon est placé, et
une pluralité d'unités de chauffage (50) disposées au sein du corps principal, la pluralité d'unités de chauffage (50) pouvant être commandées en température individuellement, **caractérisé en ce que**
le corps principal (40) a un premier substrat (51) et un deuxième substrat (52) relié au premier substrat (51),
dans lequel le premier substrat (51) a une première surface principale constituant la surface de placement et une deuxième surface principale reliée au deuxième substrat (52),
dans lequel le premier substrat (51) a une pluralité de premiers approfondissements dans la deuxième surface principale,
dans lequel la pluralité d'unités de chauffage (50) sont prévues sur des surfaces de fond des premiers approfondissements, et
dans lequel une fente d'air (54) est définie entre les unités de chauffage (50) et le deuxième substrat (52),
**caractérisé en ce que** le premier substrat est une pièce monolithe.

2. L'élément de placement selon la revendication 1, dans lequel le premier substrat (51) est fait d'un matériau d'isolation inorganique.

3. L'élément de placement selon la revendication 1 ou 2, dans lequel le premier substrat (51) est fait de carbure de silicium (SiC).

4. L'élément de placement selon l'une quelconque des revendications 1 à 3, dans lequel
le corps principal a une surface de non-placement d'un côté opposé à la surface de placement, et
la pluralité d'unités de chauffage (50) sont disposées plus proches de la surface de placement que de la surface de non-placement.

5. L'élément de placement selon l'une quelconque des revendications 1 à 4, dans lequel
les unités de chauffage (50) sont configurées par des couches minces métalliques.

6. L'élément de placement selon l'une quelconque des revendications 1 à 5, dans lequel
le corps principal a des canaux d'écoulement (75) prévus dans celui-ci le long de la surface de placement, et
le deuxième substrat (52) a une surface principale reliée à l'autre surface principale du premier substrat (51), ladite une surface principale du deuxième substrat (52) a des deuxièmes approfondissements constituant les canaux d'écoulement (75) à des parties correspondant à des parties entre des approfondissements adjacents parmi la pluralité de premiers approfondissements.

7. Un dispositif de placement à régulation de température, comportant :
l'élément de placement selon l'une quelconque de la revendication 1 à la revendication 6,
une pluralité de capteurs de température (56) configurés de manière à détecter les températures de la pluralité d'unités de chauffage, et
des moyens de contrôle configurés de manière à contrôler les températures des unités de chauffage correspondant aux capteurs de température (56) selon les températures détectées par les capteurs de température (56).
